# EUROPÄISCHE PATENTSCHRIFT

(11) **EP 0 398 456 B1**
(45) Veröffentlichungstag und Bekanntmachung des Hinweises auf die Patenterteilung: **20.09.1995**
(21) Anmeldenummer: 90250113.9
(22) Anmeldetag: 03.05.1990
(51) Int. Cl.: H03K 5/00, H03K 17/78

(54) **Schaltungsanordnung zum potentialfreien Erfassen von binären elektrischen Signalen**
Circuit arrangement for the electrically isolated reception of binary electrical signals
Montage pour la saisie électriquement isolée de signaux électriques binaires

(30) Priorität: 19.05.1989 DE 3916832
(43) Veröffentlichungstag der Anmeldung: 22.11.1990
(73) Patentinhaber: SIEMENS AKTIENGESELLSCHAFT, 80333 München (DE)
(72) Erfinder: Wenzel, Horst, D-1000 Berlin 22 (DE)

(56) Entgegenhaltungen:
- EP-A- 0 130 139
- EP-A- 0 292 804
- TOUTE L'ELECTRONIQUE, Nr. 478, November 1982,Seiten 48-56, Paris, FR; J.N. ROUSSET: "Applications spéciales des photocoupleurs"

## Beschreibung

Die Erfindung bezieht sich auf eine Schaltungsanordnung zum potentialfreien Erfassen von binären elektrischen Signalen unterschiedlicher Impulshöhe mit einem Optokoppler, der in Reihe mit einer elektronischen Schaltungseinheit an den Eingangsanschlüssen der Schaltungsanordnung liegt.

Bei einer bekannten Schaltungsanordnung dieser Art (EP-A-0 130 139 oder DE-OS 33 22 896) besteht die elektronische Schaltungseinheit aus einer Steuerschaltung, die in Reihe mit dem Optokoppler und einem Strombegrenzungswiderstand zwischen den Eingangsanschlüssen der Schaltungsanordnung liegt. Der Steuerschaltung ist bei der bekannten Schaltungsanordnung eine durch Taktimpulse steuerbare Torschaltung zugeordnet, die von einer Vorrichtung zur Spannungsbegrenzung beaufschlagbar ist; diese Vorrichtung ist zwischen den Eingangsanschlüssen der bekannten Schaltungsanordnung angeschlossen. Die Vorrichtung zur Spannungsbegrenzung enthält eine Serienschaltung aus einem Widerstand und einer Zener-Diode, der ein relativ großer Kondensator parallelgeschaltet ist, da dieser Kondensator die Energie für die Steuerschaltung bereitstellen muß. Der Ausgang des Optokopplers ist mit einer Weiterverarbeitungseinrichtung in Form einer Speichereinrichtung verbunden.

Die bekannte Schaltungsanordnung hat zwar den Vorteil, daß bei ihr der Strom zur Ansteuerung des Optokopplers unabhängig von der Impulshöhe der zu erfassenden binären elektrischen Signale ist, so daß sich Signale sehr unterschiedlicher Impulshöhe ohne Bereichsumschaltung erfassen lassen, jedoch sind zum Betrieb der bekannten Schaltungsanordnung Taktimpulse stets erforderlich.

Der Erfindung liegt die Aufgabe zugrunde, unter Beibehaltung der Vorteile der eingangs angegebenen Schaltungsanordnung diese so zu verbessern, daß sie ohne Taktimpulse betrieben werden kann.

Zur Lösung dieser Aufgabe ist bei einer Schaltungsanordnung zum potentialfreien Erfassen von binären elektrischen Signalen erfindungsgemäß die elektronische Schaltungseinheit ein Längsregler, der mit seinem Längszweig zwischen einem Eingangsanschluß der Schaltungsanordnung und dem Optokoppler liegt und mit seinem Steuereingang über eine Zener-Diode mit dem anderen Eingangsanschluß der Schaltungsanordnung verbunden ist; zwischen dem Optokoppler und dem anderen Eingangsanschluß der Schaltungsanordnung ist eine sich spannungsabhängig einschaltende Konstantstromquelle mit vorgegebener Einschaltschwelle angeordnet.

Ein wesentlicher Vorteil der erfindungsgemäßen Schaltungsanordnung besteht darin, daß sie ohne Taktimpulse arbeitet, weil allein durch den Längsregler im Zusammenwirken mit der Konstantstromquelle mit spannungsabhängiger Einschaltschwelle dafür gesorgt ist, daß bei binären elektrischen Signalen mit einer Mindestimpulshöhe an den Eingangsanschlüssen der Schaltungsanordnung am Ausgang des Längsreglers und damit in der Konstantstromquelle ein konstanter Strom fließt, der infolge der Reihenschaltung auch durch die Leuchtdiode des Optokopplers fließt, wodurch in einem großen Impulshöhenbereich der binären elektrischen Signale an den Eingangsanschlüssen ein konstanter Strom durch den Optokoppler gewährleistet ist. Eine Bereichsumschaltung für binäre elektrische Signale unterschiedlicher Impulshöhe ist also nicht erforderlich, wobei diese vorteilhafte Eigenschaft mit vergleichsweise geringem Schaltungsaufbau erreicht ist. Ein weiterer Vorteil der erfindungsgemäßen Schaltungsanordnung wird darin gesehen, daß sie ohne Kondensatoren am Eingang auskommt, so daß nach Auftreten eines binären elektrischen Signals an den Eingangsanschlüssen mit sehr kurzer Zeitverzögerung ein Ausgangssignal am Optokoppler bewirkt ist.

Die Konstantstromquelle der erfindungsgemäßen Schaltungsanordnung kann in unterschiedlicher Weise ausgebildet sein; in vorteilhafter Weise handelt es sich um eine Stromregeldiode; allein durch ein einziges Bauelement läßt sich somit die Konstantstromquelle der erfindungsgemäßen Schaltungsanordnung in wenig aufwendiger Weise verwirklichen.

Bei der erfindungsgemäßen Schaltungsanordnung hat es sich ferner als vorteilhaft erwiesen, wenn zwischen der Konstantstromquelle und dem anderen Eingangsanschluß der Schaltungsanordnung eine weitere Zener-Diode angeordnet ist. Mittels dieser weiteren Zener-Diode läßt sich in einfacher Weise definiert die Impulshöhe vorgeben, von der ab elektrische Signale an den Eingangsanschlüssen erfaßt werden sollen. Damit ist auch eine hohe Störfestigkeit erreicht.

Bei einer besonders vorteilhaften Ausführungsform der erfindungsgemäßen Schaltungsanordnung ist der Zener-Diode am Steuereingang des Längsreglers eine durch Taktimpulse steuerbare Schalteinrichtung parallel geschaltet. Der besondere Vorzug dieser Ausführungsform besteht darin, daß dadurch die Leistungsaufnahme der erfindungsgemäßen Schaltungsanordnung entsprechend dem Taktverhältnis der Taktimpulse reduziert werden kann. Dies ist insbesondere dann von großer Bedeutung, wenn bei einer größeren Meß- oder Schutzanordnung dieser über eine Vielzahl von Schaltungsanordnungen gemäß der Erfindung binäre elektrische Signale zugeführt werden sollen. Unter Verwendung der erfindungsgemäßen Schaltungsanordnung ist es möglich, auch auf kleinstem Raum relativ viele Schaltungsanordnungen zum potentialfreien Erfassen ohne Überhitzungsgefahr unterzubringen. Auch ist durch die Verwendung von Taktimpulsen ein Multiplex-Betrieb mehrerer Schaltungsanordnungen zum potentialfreien Erfassen möglich.

Die steuerbare Schalteinrichtung ist bei der erfindungsgemäßen Schaltungsanordnung in vorteilhafter Weise von einem weiteren Optokoppler gebildet, der mit der Kollektor-Emitter-Strecke seines Transistors parallel zur Zener-Diode liegt.

Zur Erläuterung der Erfindung ist in
- Figur 1: ein Blockschaltbild eines Ausführungsbeispiels der erfindungsgemäßen Schaltungsanordnung und in
- Figur 2: ein detaillierteres Schaltbild desselben Ausführungsbeispiels wiedergegeben.

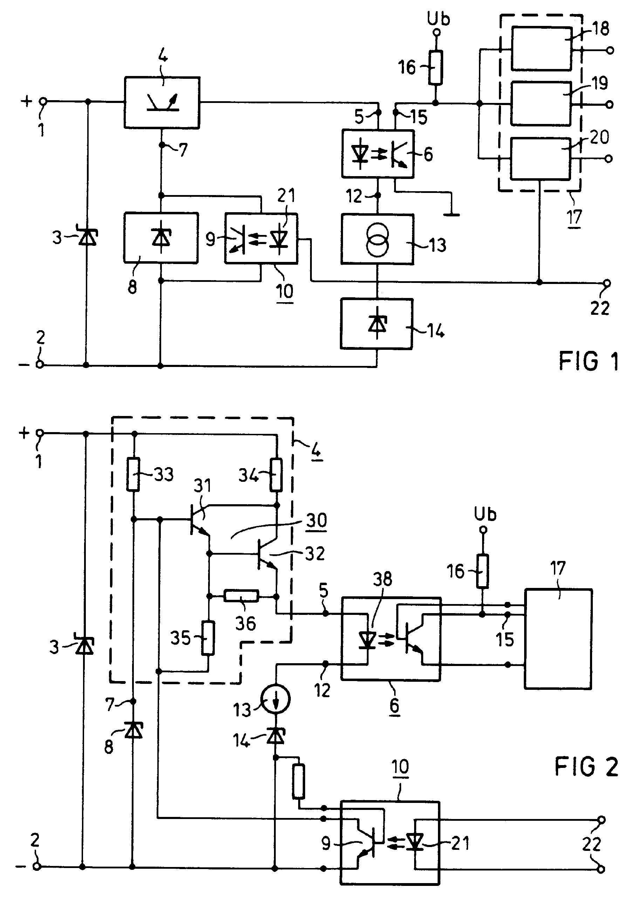

Die in Figur 1 dargestellte Schaltungsanordnung weist Eingangsanschlüsse 1 und 2 auf, die mit binären elektrischen Signalen unterschiedlicher Impulshöhe beaufschlagbar sind. Die Eingangsanschlüsse 1 und 2 sind über eine Schutzdiode 3 miteinander verbunden. Ferner weist die dargestellte Schaltungsanordnung einen Längsregler 4 auf, der mit seinem Längszweig einerseits an den einen Eingangsanschluß 1 und andererseits an einen Anschlußpunkt 5 eines Optokopplers 6 angeschlossen ist. Der Steuereingang 7 des Längsreglers 4 ist über eine Zener-Diode 8 mit dem anderen Eingangsanschluß 2 der Schaltungsanordnung verbunden. Parallel zu der Zener-Diode 8 liegt eine steuerbare Schalteinrichtung, die von dem Transistor 9 eines weiteren Optokopplers 10 gebildet ist.

Der eine Optokoppler 6 ist hinsichtlich seines weiteren Anschlußpunktes 12 mit einer Konstantstromquelle 13 verbunden, die auch über eine weitere Zener-Diode 14 mit dem anderen Eingangsanschluß 2 der Schaltungsanordnung in Verbindung steht.

Ein zusätzlicher Anschlußpunkt 15 des einen Optokopplers 6 ist über einen Widerstand 16 an eine Betriebsspannungsquelle Ub gelegt. Außerdem ist an diesen Anschlußpunkt 15 eine Weiterverarbeitungseinrichtung 17 angeschlossen, die in dem dargestellten Ausführungsbeispiel eine Einrichtung zum Speichern 18, eine weitere Einrichtung zum Verzögern 19 und eine zusätzliche Einrichtung 20 zum Durchführen eines Multiplex-Betriebes enthält.

Die Einrichtung 20 ist übrigens ebenso wie die Diode 21 des weiteren Optokopplers 21 mit einem in der Figur nicht dargestellten Taktgeber über einen Eingang 22 verbunden.

Die Figur 2 läßt erkennen, daß der Längsregler 4 unter anderem eine Darlington-Stufe 30 mit Transistoren 31 und 32 sowie Widerständen 33, 34, 35 und 36 enthält. Wie sich anhand einer praktisch aufgebauten Schaltung erwiesen hat, ist der Längsregler 4 im Zusammenwirken mit der einen Zener-Diode 14 so auslegbar, daß bei binären elektrischen Eingangssignalen mit Impulshöhen zwischen 19 und 288 V am Ausgang 5 des Längsreglers 4 eine Spannung von etwa 15 V vorhanden ist. Ferner ist bei der ausgeführten Schaltung mit einer von einer Stromregel-Diode 13 gebildeten Konstantstromquelle, wie sie in dem "Low Power Discretes Data Book" der Firma Siliconix , 1989 auf den Seiten 4-61 und 4-91 beschrieben ist, erreicht, daß durch die Leuchtdiode 38 des Optokopplers 6 ein Strom von 2 mA fließt, wobei dieser Strom in dem angegebenen Impulshöhenbereich weitestgehend unverändert bleibt.

Wird die Leucht-Diode 21 des weiteren Optokopplers 10 über den Eingang 22 mit Taktimpulsen beaufschlagt, dann wird dadurch der Transistor 9 dieses Optokopplers durchlässig, wodurch die Basis des Transistors 31 der Darlington-Stufe 30 auf das Potential des anderen Eingangsanschlusses 2 der Schaltungsanordnung gelegt wird. Es fließt dann kein Strom mehr durch den Längsregler 4, und es wird von der gesamten Schaltungsanordnung dann keine Leistung mehr aufgenommen. Je nach Taktverhältnis der Taktimpulse am Eingang 22 kann die Leistungsaufnahme der Schaltungsanordnung reduziert werden. Im jeweils abgeschalteten Zustand, das heißt bei fehlender Beaufschlagung des weiteren Optokopplers 10 mit Taktimpulsen, ist allerdings die Schaltungsanordnung nicht zur sofortigen Übernahme von elektrischen Signalen an den Eingangsanschlüssen 1 und 2 bereit.

Sofern ein weitestgehend unverzögertes Ansprechen der Schaltungsanordnung auf elektrische Signale an ihren Eingangsanschlüssen 1 und 2 erwünscht ist, wird auf eine Beaufschlagung der Schaltungsanordnung mit Taktimpulsen verzichtet. In diesem Fall bleibt die Darlington-Stufe 30 des Längsreglers 4 aktiviert, so daß unmittelbar nach Auftreten von binären elektrischen Signalen an den Eingangsanschlüssen 1 und 2 ein Strom durch die Leuchtdiode 38 des einen Optokopplers 6 getrieben wird, der in der Weiterverarbeitungseinrichtung 17 als Anzeichen für das Auftreten des Eingangssignals gewertet wird.

## Patentansprüche

1. Schaltungsanordnung zum potentialfreien Erfassen von binären elektrischen Signalen unterschiedlicher Impulshöhe mit einem Optokoppler (6), der in Reihe mit einer elektronischen Schaltungseinheit (4) an den Eingangsanschlüssen (1,2) der Schaltungsanordnung liegt,
**dadurch gekennzeichnet,** daß
die elektronische Schaltungseinheit ein Längsregler (4) ist, der mit seinem Längszweig zwischen dem einen Eingangsanschluß (1) der Schaltungsanordnung und dem Optokoppler (6) liegt und mit seinem Steuereingang (7) über eine Zener-Diode (8) mit dem anderen Eingangsanschluß (2) der Schaltungsanordnung verbunden ist, und daß
zwischen dem Optokoppler (6) und dem anderen Eingangsanschluß (2) der Schaltungsanordnung eine sich spannungsabhängig einschaltende Konstantstromquelle (13) mit vorgegebener Einschaltschwelle angeordnet ist.

2. Schaltungsanordnung nach Anspruch 1,
**dadurch gekennzeichnet,** daß
die Konstantstromquelle eine Stromregeldiode (13) ist.

3. Schaltungsanordnung nach Anspruch 1 oder 2,
**dadurch gekennzeichnet,** daß
zwischen der Konstantstromquelle (13) und dem anderen Eingangsanschluß (2) der Schaltungsanordnung eine weitere Zener-Diode (14) angeordnet ist.

4. Schaltungsanordnung nach einem der vorangehenden Ansprüche,
**dadurch gekennzeichnet,** daß
der Zener-Diode (8) am Steuereingang (7) des Längsreglers (4) eine durch Taktimpulse steuerbare Schalteinrichtung (9) parallelgeschaltet ist.

5. Schaltungsanordnung nach Anspruch 4,
**dadurch gekennzeichnet,** daß
die steuerbare Schalteinrichtung von einem weiteren Optokoppler (10) gebildet ist, der mit der Kollektor-Emitter-Strecke seines Transistors (10) parallel zur Zener-Diode (8) liegt.

## Claims

1. Circuit arrangement for the potential-free detection of binary electrical signals of differing pulse level with an optical coupler (6) which lies in series with an electronic circuit unit (4) at the input terminals (1, 2) of the circuit arrangement, characterized in that the electronic circuit unit is an in-phase regulator (4) which lies with its series arm between the one input terminal (1) of the circuit arrangement and the optical coupler (6) and is connected by its control input (7) by way of a Zener diode (8) to the other input terminal (2) of the circuit arrangement, and in that a constant current source (13) connecting in a voltage-dependent manner with specified starting threshold is arranged between the optical coupler (6) and the other input terminal (2) of the circuit arrangement.

2. Circuit arrangement according to claim 1, characterized in that the constant current source is a current-control diode (13).

3. Circuit arrangement according to claim 1 or 2, characterized in that a further Zener diode (14) is arranged between the constant current source (13) and the other input terminal (2) of the circuit arrangement.

4. Circuit arrangement according to one of the preceding claims, characterized in that a switching device (9) controllable by clock pulses is connected in parallel with the Zener diode (8) at the control input (7) of the in-phase regulator (4).

5. Circuit arrangement according to claim 4, characterized in that the controllable switching device is formed by a further optical coupler (10) which lies with the collector-emitter path of its transistor (10) in parallel with the Zener diode (8).

## Revendications

1. Montage pour détecter, sans potentiel, des signaux électriques binaires ayant différentes amplitudes d'impulsions, comportant un optocoupleur (6), qui est raccordé, en série avec une unité de circuit électronique (4), aux bornes d'entrée (1,2) du montage, caractérisé par le fait
que l'unité de circuit électronique est un régulateur longitudinal (4), dont la branche longitudinale est située entre l'une (1) des bornes d'entrée du montage et l'optocoupleur (6), et dont l'entrée de commande (7) est reliée, par l'intermédiaire d'une diode Zener (8), à l'autre borne d'entrée (2) du montage, et
qu'entre l'optocoupleur (6) et l'autre borne d'entrée (2) du montage est disposée une source de courant constant (13), qui se met en marche en fonction de la tension et qui a un seuil de mise en marche prescrit.

2. Montage suivant la revendication 1, caractérisé par le fait que la source de courant constant est une diode de régulation de courant (13).

3. Montage suivant la revendication 1 ou 2, caractérisé par le fait qu'une autre diode Zener (14) est disposée entre la source de courant constant (13) et l'autre borne d'entrée (2).

4. Montage suivant l'une des revendications précédentes, caractérisé par le fait qu'un dispositif de commutation (9) commandable par des impulsions de cadence est branché en parallèle avec la diode Zener (8) à l'entrée de commande (7) du régulateur longitudinal (4).

5. Montage suivant la revendication 4, caractérisé par le fait que le dispositif de commutation commandable est formé par un autre optocoupleur (10), la voie collecteur-émetteur du transistor (10) de cet optocoupleur étant branchée en parallèle avec la diode Zener (8).
